# EUROPÄISCHE PATENTSCHRIFT

(11) **EP 2 559 126 B1**
(45) Veröffentlichungstag und Bekanntmachung des Hinweises auf die Patenterteilung: **28.01.2015**
(21) Anmeldenummer: 11743953.9
(22) Anmeldetag: 29.03.2011
(51) Int. Cl.: H02G 15/013, G01D 1/00, G01D 15/00, H01B 17/30, H03K 17/95

(54) **DURCHFÜHRUNG EINES ELEKTRISCHEN LEITERS**
BUSHING OF AN ELECTRICAL CONDUCTOR
TRAVERSÉE D'UN CONDUCTEUR ÉLECTRIQUE

(30) Priorität: 21.05.2010 DE 202010007043 U; 15.04.2010 DE 202010005098 U
(43) Veröffentlichungstag der Anmeldung: 20.02.2013
(73) Patentinhaber: Micro-Epsilon Messtechnik GmbH & Co. KG, 94496 Ortenburg (DE)
(72) Erfinder: MEILHAMER, Alfons, 94094 Rotthalmünster (DE); HOENICKA, Reinhold, 94496 Ortenburg (DE)
(74) Vertreter: Naumann, Ulrich
(86) Internationale Anmeldenummer: PCT/DE2011/000330
(87) Internationale Veröffentlichungsnummer: WO 2011/127889

(56) Entgegenhaltungen:
- WO-A1-2007/098315
- FR-A- 868 638
- FR-A- 1 474 348
- GB-A- 2 248 526
- US-A- 3 007 130
- US-A- 3 025 488

## Beschreibung

Die Erfindung betrifft eine Durchführung eines elektrischen Leiters durch eine zwei Bereiche voneinander trennende Wand, wobei sich der Leiter durch einen Durchgang in der Wand, zu dieser beabstandet, erstreckt.

Einleitend sei angemerkt, dass sich die Erfindung auf jedwede Durchführungen bezieht, wobei es hier um eine Durchführung durch eine zwei Bereiche voneinander trennende Wand geht. Aus der Praxis sind hermetisch dichte Glas-Metall-Durchführungen bekannt. Solche Durchführungen werden beispielsweise dort eingesetzt, wo elektrische Signale oder elektrische Energie kontaktbehaftet durch eine Trennwand hindurchzuführen sind, wobei die Trennwand zwei Bereiche voneinander trennt. Die Trennwand ist als Wandung, Barriere, Grenzfläche oder dergleichen im weitesten Sinne zu verstehen.

Eine solche Wand oder Trennwand dient üblicherweise dazu, die hier in Rede stehenden Bereiche derart voneinander abzugrenzen, dass beliebige Medien, Felder oder Temperaturen nicht unmittelbar von dem ersten Bereich in den zweiten Bereich gelangen. Als Beispiel lässt sich die Trennung zweier Bereiche in Bezug auf Gase nennen, wobei hier insbesondere die Trennung von Bereichen mit unterschiedlichem Druck bzw. Vakuum gegenüber atmosphärischem Druck von Interesse ist. Gleiches gilt für Flüssigkeiten, für feste Stoffe (beispielsweise Staub, Pulver, Granulat, Schüttgüter jedweder Art, etc.), für elektrische oder magnetische Felder, für Temperaturen etc.

Jedenfalls erfordert die Durchführung von elektrischen Signalen oder elektrischer Energie durch eine Trennwand eine ganz besondere Abdichtung der Durchführung, um nämlich den unerwünschten Austausch der Medien zwischen den beiden Bereichen zu verhindern.

Sofern es sich bei der Wand um einen elektrischen Leiter handelt, sind an die Durchführung weitere Anforderungen zu stellen, muss nämlich die Durchführung von der Wand elektrisch isoliert werden. Dazu sind aus der Praxis unterschiedliche Möglichkeiten bekannt, beispielsweise das Vergießen, Verkleben, Einpressdichtungen aus elastischem Material wie Gummi etc.

Als elektrische Leiter zur Durchführung durch die Wand werden häufig metallische Kontaktstifte verwendet, die durch die Wand hindurch gesteckt und gegen die Wand isolierend abgedichtet werden. Solche Kontaktstifte lassen sich in Kunststoff einpressen oder in einer Metalldurchführung mittels gießbarem Kunststoff, beispielsweise mittels Epoxidharz, vergießen.

Sofern die Durchführung hermetisch dicht sein soll, so dass beispielsweise kein Austausch von Gasen zwischen den beiden Bereichen stattfindet, sind an die Isolierung hohe Anforderungen zu stellen. Die Durchführungen müssen in einem solchen Falle druckdicht sein oder es kann zusätzlich erforderlich sein, dass aggressive Medien wirkungsvoll voneinander getrennt werden.

Aus der Praxis sind bereits seit Jahren Glas-Metall-Durchführungen bekannt, bei denen die elektrischen Kontakte mittels einer Glasschmelze in einem in der Wand angelegten Durchgang fixiert und gleichzeitig abgedichtet werden. Zu dessen Herstellung wird Glas unter hohen Temperaturen derart erweicht, dass es gießfähig ist und dabei den Raum zwischen dem Kontaktstift und der Trennwand ausfüllen kann. Nach dem Abkühlen ist eine hinreichend gute Abdichtung geschaffen.

Bei den aus der Praxis bekannten Durchführungen bzw. Verbindungen unterscheidet man zwischen den sog. "angepassten" Verbindungen und den "nicht-angepassten" Verbindungen. Bei den angepassten Verbindungen werden Materialien verwendet, deren thermische Ausdehnungskoeffizienten sich nicht oder nur gering voneinander unterscheiden. Dies führt dazu, dass die Glas-Metall-Verbindung nach dem Abkühlen keine oder kaum innere Spannungen aufweist. Die Fixierung und Abdichtung erfolgt in diesem Falle durch Adhäsion in der Grenzfläche zwischen Metall und Glas. Es ist darauf zu achten, dass die jeweiligen Grenzflächenenergien eine ausreichende Adhäsion zulassen. Gegebenfalls ist es erforderlich, die Metalloberflächen in Bezug auf die Oberflächenspannung/Grenzflächenenergie zu behandeln, beispielsweise zu beschichten.

Bei nicht-angepassten Verbindungen liegen unterschiedliche thermische Ausdehnungskoeffizienten der Materialien vor. Dies führt dazu, dass neben der reinen Adhäsion eine innere Verspannung der Verbindung zur Abdichtung nutzbar ist, wobei darauf zu achten ist, dass die verwendeten Materialien den auftretenden Spannungen standhalten.

Glas-Metall-Durchführungen sind in unterschiedlichsten Ausführungen auf dem Markt. Es werden üblicherweise Kontaktstifte verwendet, die mittels einer Glasisolierung in einem Metallgehäuse angeordnet bzw. fixiert sind. Dabei kann es sich beispielsweise um Durchführungen mit einem Metallflansch handeln, der in der Trennwand mittels Schweißen, Verschrauben, O-Ring-Dichtung oder unter Zugrundelegung anderer geeigneter Verfahren angebracht wird. Die Kontaktstifte sind regelmäßig funktional ausgestaltet, können beispielsweise die Kontakte eines Steckers sein. Die weitere Kontaktierung erfolgt dann mit einem dazu passenden Gegenstecker.

Auch ist es denkbar, Kontakte löt- oder schweißtechnisch darzustellen, an die dann ein weiterführender Leiter, beispielsweise eine Kabellitze oder ein sonstiger Anschlussdraht, mittels Löten oder Schweißen angebracht wird. Ebenso sind aus der Praxis Kontaktstifte bekannt, auf denen ein Leiter auf-/angecrimpt wird.

Zum einschlägigen Stand der Technik sei verwiesen auf die DE 963 806 A, woraus ein vakuumdichte Einschmelzung für Stromdurchführungen in Entladungsröhren bekannt ist. Die dort vorgesehene Wandung besteht zumindest teilweise aus Metall, wobei der Stromleiter direkt unter Zwischenfügung von Glas mit einem buchsenoder hülsenförmigen Metallgebilde verbunden ist.

Aus der US 4,029,897 ist für sich gesehen eine hermetische Glasdichtung zwischen elektrisch leitfähigen Komponenten unter Nutzung besonderer Dichtungsstrukturen bekannt. Des Weiteren sei verwiesen auf die US 4,841,101 sowie auf die DE 101 17976A1.

Aus der FR1474348A1 ist eine Durchführung eines elektrischen Leiters durch eine zwei Bereiche voneinander trennende Wand bekannt. Dabei erstreckt sich der Leiter im Durchgang durch eine elektrisch isolierte und hermetisch abgedichtete Hülse. Die Hülse ist an einem Ende mittels eines Lötrings formschlüssig mit dem Leiter verbunden.

Der vorbekannte Stand der Technik ist in mehrerlei Hinsicht problematisch. Dazu Folgendes:
Die Kontakte von Durchführungen müssen bei angepassten Verbindungen aus einem Material hergestellt sein, welches sich auf Grund seiner thermischen Ausdehnungskoeffizienten hinreichend gut eignet. Solche Materialien lassen sich üblicherweise nicht oder nur schlecht löten. Hierbei handelt es sich häufig um Titan, Wolfram, Molybdän oder Eisen-Verbindungen. Solche Materialien lassen sich nur nach vorheriger Behandlung der Oberfläche, beispielsweise durch Aufbringen einer dünnen Kontaktschicht aus Gold oder Silber, mit üblichen Leitern löttechnisch verbinden.

Die Verwendung konventioneller Kontaktstifte erfordert üblicherweise einen erheblichen Bauraum für die Durchführung durch die jeweilige Wand. Besonders bei Verwendung von Gegensteckern wird der Bauraum abermals in erheblichem Maße verlängert, da Gegenstecker langgestreckte Bauteile mit erheblicher Dimensionierung sind.

Auch bei Löt- oder Schweißverbindungen ist ein erheblicher Bauraum erforderlich, da die Löt- bzw. Schweißstellen regelmäßig außerhalb der Durchführung liegen.

Außerdem ist bei den bekannten Löt- und Schweißverbindungen nachteilig, dass diese bei mechanischen Beanspruchungen, beispielsweise auf Grund von Schock oder Vibration oder bei Zug- oder Druckbelastungen, brechen können. Insoweit ist es erforderlich, eine mechanische Fixierung der Kontaktstelle oder eine Zugentlastung des Leiters zu generieren, wodurch sich der Bauraum abermals vergrößert, insbesondere das jeweilige Bauteil verlängert.

Ein weiterer Nachteil der aus der Praxis bekannten Durchführungen ist darin zu sehen, dass auf beiden Seiten der bekannten Durchführung die Kontakte separat zu kontaktieren sind. Insoweit erhöht sich die Fehleranfälligkeit auf Grund der Reihenschaltung von mindestens zwei Verbindungen unterschiedlicher oder gleicher Verbindungstechnik. Die aus der Praxis bekannten Steckverbindungen sind außerdem fehleranfällig und teuer, da die Sicherheit des Kontakts beim Stecken nur durch besondere konstruktive Maßnahmen dauerhaft sichergestellt werden kann.

Bei Verwendung unterschiedlicher Materialien für die Kontaktstifte und die elektrischen Leiter besteht außerdem die Gefahr, dass auf Grund des Seebeck-Effekts Thermospannungen induziert werden, die wiederum elektrische Signale beeinflussen.

Schließlich ist es bei Verwendung unterschiedlicher Materialien nachteilig, dass diese auf Grund der elektrochemischen Spannungsreihe zur Korrosion neigen. Es entstehen Übergangswiderstände. Außerdem droht eine Zerstörung der Verbindung.

Der vorliegenden Erfindung liegt daher die Aufgabe zu Grunde, eine Durchführung eines elektrischen Leiters durch eine zwei Bereiche voneinander trennende Wand anzugeben, bei der die zuvor aufgezeigten Nachteile eliminiert, zumindest aber ganz erheblich reduziert sind. Die Durchführung soll eine möglichst geringe Baulänge aufweisen, wobei eine hermetische Abdichtung einerseits und eine gute elektrische Kontaktierung andererseits gewährleistet sein muss. Die Durchführung soll bei hinreichender mechanischer Stabilität einfach in der Konstruktion und günstig in der Herstellung sein.

Voranstehende Aufgabe ist durch die Merkmale des Patentanspruchs 1 gelöst. Danach ist die gattungsbildende Durchführung dadurch gekennzeichnet, dass sich vorzugsweise in etwa koaxial durch den Durchgang hindurch eine gegenüber dem Durchgang elektrisch isolierte und hermetisch abgedichtete Hülse erstreckt und dass sich der elektrische Leiter durch die Hülse hindurch erstreckt und hermetisch abdichtend, vorzugsweise materialschlüssig; durch Weich - oder Hartlöten über die gesamte Länge der Hülse, mit der Hülse verbunden ist.

In vorteilhafter Weise ist erkannt worden, dass sich die Durchführung eines elektrischen Leiters durch eine zwei Bereiche trennende Wand ganz einfach dadurch realisieren lässt, dass man den zur Durchführung erforderlichen Durchgang mit einer Hülse versieht, die gegenüber der Wand abgedichtet ist. Grundsätzlich kann es sich bei der Hülse um ein Bauteil aus jedweden Materialien handeln, wobei auf eine vorteilhafte Materialwahl später noch eingegangen wird.

Grundsätzlich spielt es keine Rolle, wie sich die Hülse durch den Durchgang und somit durch die Wand hindurch erstreckt. Sollte es sich bei dem verwendeten Hülsenmaterial um einen Isolator handeln, wäre die Abdichtung zwischen der Hülse und der Wand lediglich in Bezug auf eine hermetische Abdichtung auszulegen.

Sofern es sich bei der Hülse um eine elektrisch leitendes Material handelt, ist es erforderlich, dass die Hülse in dem Durchgang, gegenüber dem Material der Wand, elektrisch isoliert ist. Eine hermetisch abdichtende Wirkung ist zudem erforderlich.

Der elektrische Leiter erstreckt sich durch die Hülse hindurch, und zwar ebenfalls abdichtend, wobei vorzugsweise eine materialschlüssige Einbindung des elektrischen Leiters in die Hülse vorgesehen ist. Mit anderen Worten kann der elektrische Leiter materialschlüssig in die Hülse eingebunden sein, wobei die Hülse in den Durchgang der Wand eingebunden ist, nämlich vorzugsweise gegenüber der Wand elektrisch isoliert und mit hermetisch abdichtender Wirkung zwischen Hülse und Wand.

Die Vorkehrung der Hülse und die doppelte Einbindung - einerseits des elektrischen Leiters in der Hülse und andererseits der Hülse im Durchgang - schaffen mit einfachen Mitteln eine wirkungsvolle Durchführung durch eine Wand, die unterschiedliche Bereiche voneinander trennt. In vorteilhafter Weise ist die Abdichtung der Hülse gegenüber dem Durchgang als Vergußmittel, beispielsweise aus Kunststoff, ausgeführt. Ebenso ist es denkbar, dass die Abdichtung im Sinne einer Verglasung ausgeführt ist, wie sie für sich gesehen bereits aus dem Stand der Technik bekannt ist. So lassen sich die Abdichtungen hermetisch dicht ausführen, und zwar mit einer Wirkung zwischen der zuvor genannten Hülse und dem Material der Wand.

Die Hülse kann aus unterschiedlichsten Materialien bestehen, vorzugsweise aus Metall. Es kann sich bei der Hülse um ein elektrisch leitfähiges Material handeln. In vorteilhafter Weise besteht die Hülse aus dem gleichen Material oder einem ähnlichen Material wie der elektrische Leiter.

Die Hülse lässt sich beispielsweise aus einer Eisen-Nickel-Legierung herstellen.

In Bezug auf die Abdichtung der Hülse gegenüber der Wand ist es denkbar, dass das Material der Abdichtung in etwa die gleiche thermische Ausdehnung wie die Hülse hat. Durch diese Maßnahme lassen sich Spannungen in der Durchführung vermeiden. In ganz besonders vorteilhafter Ausgestaltung hat die Abdichtung der Hülse gegenüber der Wand eine geringere thermische Ausdehnung als das Material der Wand. Eine solche Ausführung hat einen enormen Vorteil, wenn die Wand die Abdichtung zumindest teilweise umgibt und beim Abkühlen auf Grund der größeren Schrumpfung die Wand regelrecht auf die Abdichtung aufgeschrumpft wird. Auf Grund der so auftretenden äußeren Spannungen auf die beispielsweise aus Glas hergestellte Abdichtung ergibt sich eine höhere Druckbeständigkeit der Abdichtung, die wiederrum das Einsatzspektrum vergrößert.

Der elektrische Leiter kann als Litze, beispielsweise aus Kupferlitze, ausgeführt sein. Beliebige andere elektrische Leiter lassen sich unter Berücksichtigung einer geeigneten Materialanpassung der an der Durchführung beteiligten Materialien realisieren.

In vorteilhafter Weise ist der elektrische Leiter durch Weich- oder Hartlöten, vorzugsweise über die gesamte Länge der Hülse hinweg, in diese eingebunden. Dies hat den Vorteil, dass eine innere Kontaktierung des elektrischen Leiters an eine leitfähige Hülse realisiert ist, an der wiederum weitere Kontaktierungen - anschlussseitig - möglich sind.

In besonders vorteilhafter Weise handelt es sich bei der Wand um den Teil eines Gehäuses eines Sensors, vorzugsweise eines induktiven Wegsensors. Dabei ist der elektrische Leiter vorzugsweise der Spulendraht des Sensors, wobei es um die elektrischen Kontaktierung zwischen der Spule bzw. den Spulen und einem Anschlusskabel geht. Der Anschlussdraht ist an das anschlussseitige Ende der Hülse an diese und/oder an den elektrischen Leiter bzw. an den Spulendraht angelötet. Die Realsierung von Steckverbindungen oder sonstigen elektrischen Verbindungen bleibt unbenommen.

Zur Herbeiführung einer weiterreichenden Stabilität ist es von Vorteil, wenn der anschlussseitige Bereich im Sensorgehäuse mit einer Vergußmasse ausgefüllt ist, die die Kontaktierung des elektrischen Leiters bzw. der Hülse und das Anschlusskabels umgibt. Durch diese Maßnahme ist einerseits eine weiterreichende Abdichtung und andererseits eine mechanische Stabilisierung realisiert.

Die erfindungsgemäße Durchführung ist im Vergleich zu dem nachgewiesenen druckschriftlichen Stand der Technik von Vorteil, wobei im Rahmen der erfindungsgemäßen Ausprägung der Hülse als hohler, rohrförmiger Kontakt, eine ganz besondere Bedeutung zukommt. Diese Hülse ist mittels eines isolierenden Materials in einem Durchgang der Wand fixiert, wobei sich der elektrische Leiter durch die Hülse hindurch erstreckt. Eine materialschlüssige Verbindung, beispielsweise durch Verlöten, fixiert den elektrischen Leiter in der Hülse, die wiederrum im Durchgang der Wand festgelegt ist.

Wie bereits zuvor erwähnt ist zwischen der Hülse und dem Durchgang der Wand ein Vergußmittel oder eine Verglasung vorgesehen, wobei es sich bei dem Vergußmittel um ein Epoxidharz handeln kann.

Eine Verglasung bringt den enormen Vorteil mit sich, dass sich dadurch eine Vakuumdichtigkeit bis zu 10⁻⁹ mbar*l/s bei einem Differenzdruck von 1 bar realisieren lässt. Letztendlich lässt sich durch die Verglasung eine hermetische Abdichtung erzeugen.

Da die Hülse aus dem gleichen Material wie der elektrische Leiter bestehen kann, lässt sich der elektrische Leiter in hervorragender Weise mit der Hülse verbinden, nämlich durch die Hülse hindurchführen und im Inneren der Hülse durch Weich- oder Hartlöten mit dem Inneren der Hülse materialschlüssig verbinden. Bei geeigneter Wahl von Materialen und Abmessungen von elektrischem Leiter und Hülse ist es denkbar, dass das Lötmittel beim Löten in die Hülse regelrecht hineingezogen wird und die Hülse im Inneren vollständig ausfüllt, nämlich auf Grund von dort auftretender Kapillarwirkung.

Es ist in erfindungsgemäßer Weise erreicht, dass sich die Kontaktierung, in diesem Fall die Lötstelle, nicht außerhalb der Hülse und somit der eigentlichen Kontaktstelle befindet, sondern innerhalb der Hülse. Folglich ist die Kontaktstelle innerhalb der Hülse hinreichend gut geschützt und liegt vor allem innerhalb des hermetisierten bzw. abgedichteten Bereichs. Auch dies ist von enormen Vorteil.

In erfindungsgemäßer Weise lässt sich die Durchführung kompakt bzw. kurz bauen, wodurch sich unterschiedlichste Anwendungen ergeben. Dies gilt beispielsweise für die Medizintechnik bei implantierbaren Geräten, in der Sensorik bei miniaturisierten Sensoren, auch in der Luft- und Raumfahrt, wo kompakte und besonders leichte Komponenten erforderlich sind. Eine abschließende Aufzählung der Einsatzmöglichkeiten ist auf Grund der vielfältigen Anwendungen nicht möglich.

An dieser Stelle sei noch einmal ganz besonders hervorgehoben, dass das Lot innerhalb der Hülse einen elektrischen Kontakt, eine mechanische Verbindung und darüber hinaus eine hermetische Abdichtung herstellt. Auch lässt sich eine Zugentlastung durch die Kontaktstelle erreichen. Außerdem ist ein einfaches Vergießen des Leiters innerhalb der Hülse ohne zusätzliche konstruktive Maßnahmen möglich.

Aus der erfindungsgemäßen Durchführung ergeben sich enorme Vorteile, insbesondere in Bezug auf eine dauerhaft dichte Vakuumdurchführung bei Hochvakuum. Es lassen sich zuverlässig Druckdurchführungen realisieren, vor allem auch Durchführungen bei aggressiven Medien in einem jeweiligen Bereich. Durchführungen in zu implantierenden Geräten, beispielsweise bei Herzschrittmachern in der Medizintechnik, sind realisierbar.

Insbesondere in der Sensorik ergeben sich Vorteile in Bezug auf Dichte und temperaturbeständige Sensoren bei schwierigen Umgebungsbedingungen.

Sensoren und Aktoren für Luft- und Raumfahrt lassen sich entsprechend ausstatten. Auch in der Halbleitertechnik, beispielsweise bei einem Ultra-Clean-Vakuum bei Maschinen zur Herstellung von Halbleitern, lassen sich entsprechende Durchführungen realisieren.

Hermetische Dichtigkeiten bis 10⁻⁹ mbar*l/s [delta p=1 bar] sind realisierbar, wobei eine nur einseitige Kontaktierung erforderlich ist. Die einzige Kontaktstelle liegt im geschützten hermetisierten Bereich. Dadurch ergibt sich gleichzeitig eine kompakte Bauweise im Außenbereich, wobei dies eine besondere Relevanz für die Sensor- und Medizintechnik hat. Eine Zugentlastung der elektrischen Leiter bzw. des Kabels ist in erfindungsgemäßer Weise realisiert.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert.

In der Zeichnung zeigt
- Fig. 1: in einer schematischen Ansicht, teilweise geschnitten, ein erstes Ausführungsbeispiel erfindungsgemäßer Durchführungen und
- Fig. 2: in einer schematischen Ansicht ein zweites Ausführungsbeispiel einer erfindungsgemäßen Durchführung in einem induktiven Wegsensor.

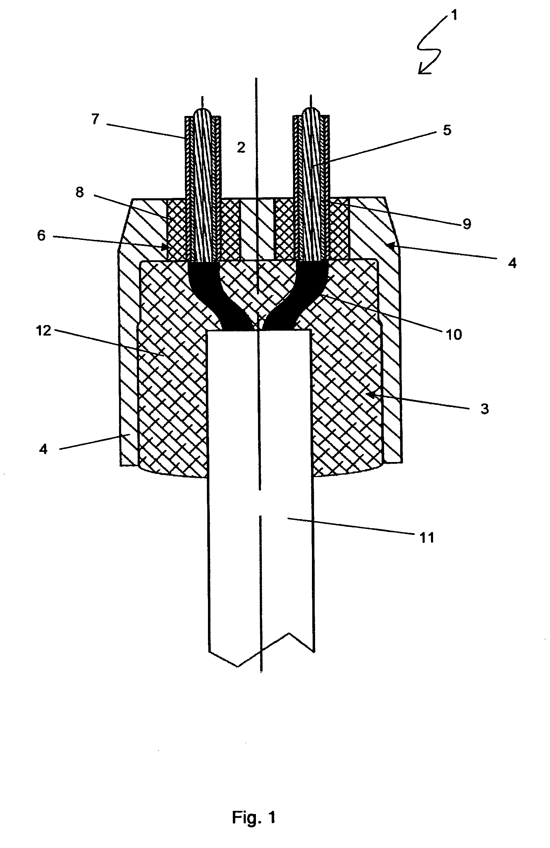

Fig. 1 zeigt in einer schematischen Ansicht, teilweise geschnitten, eine besondere Ausführungsform einer erfindungsgemäßen Durchführung 1, wobei diese durch eine zwei Bereiche 2, 3 voneinander trennende Wand 4 angelegt ist, nämlich durch die Wand 4 hindurch geführt ist.

Genauer gesagt erstreckt sich durch einen Durchgang 6 in der Wand 4 hindurch eine Hülse 7 aus elektrisch leitendem Material, wobei die Hülse 7 gegenüber der Wand 4 elektrisch isoliert und dabei hermetisch abdichtend angelegt ist. Bei der Isolation zwischen der Hülse 7 und der Wand 4 handelt es sich um eine Verglasung 8.

Die Verglasung 8 wirkt zwischen der Wand 4 und der Hülse 7. Durch die Verglasung 8 ist die Hülse 7 sicher positioniert und gegenüber dem Material der Wand 4 elektrisch abgedichtet.

Innerhalb der Hülse 7 erstreckt sich der elektrische Leiter 5, wobei dieser in der Hülse 7 materialschlüssig mit der Innenwandung der Hülse 7 verbunden ist, nämlich mittels Hart- oder Weichlot 9. Somit ist innerhalb der Hülse 7 eine innere Kontaktierung des elektrischen Leiters 5 realisiert. Bei dem elektrischen Leiter 5 kann es sich um eine Kabellitze als Bestandteil des Anschlusskabels 11 handeln. An dieser Stelle sei angemerkt, dass es sich bei dem elektrischen Leiter auch um die sogenannten Beinchen bzw. Anschlussdrähte elektrischer/elektronischer Bauteile handeln kann, beispielsweise um die Anschlussdrähte von Dioden, Widerständen oder sonstigen Funktionselementen.

Anschlussseitig ist die Litze 5 der Kabelader 10 löttechnisch mit der Hülse 7 verbunden. Der anschlussseitige Bereich ist durch eine Vergußmasse 12 vergossen, wodurch sich eine zusätzliche Abdichtung bei gleichzeitiger mechanischer Stabilisierung ergibt. Gleichzeitig ist eine Zugentlastung in Bezug auf das Anschlusskabel realisiert, wobei obendrein die Kontaktstelle gegenüber Umgebungseinflüssen geschützt ist.

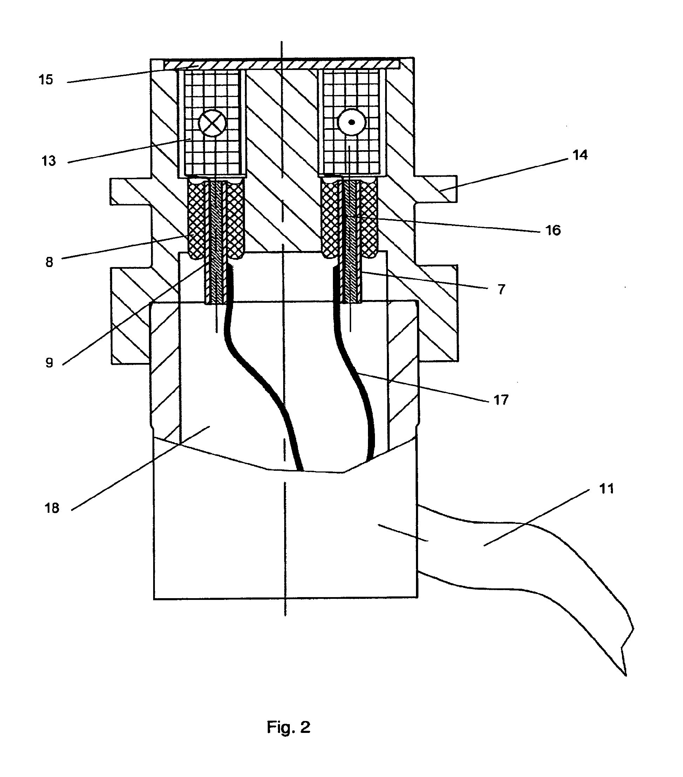

Fig. 2 zeigt ein weiteres Ausführungsbeispiel einer erfindungsgemäßen Durchführung 1 am Beispiel eines induktiven Wegsensors. Die Kontaktierung wird zwischen der Spule 13 und dem Anschlusskabel 11 mittels einer erfindungsgemäßen Durchführung 1 hergestellt.

Das Sensorgehäuse 14 repräsentiert die Wand zwischen den Bereichen und besteht aus Metall, beispielsweise aus Edelstahl. Es umfasst die Spule 13.

Die Spule 13 ist stirnseitig mit einer Abdeckkappe 15 gegen die Umgebung geschützt.

Der Spulendraht 16 ist durch die Hülse 7 hindurchgeführt und dort mittels Weichlot 9 mit dem Inneren der Hülse 7 löttechnisch verbunden.

Am gegenüberliegenden Ende ist die Anschlusslitze 17 des Anschlusskabels 11 von außen an die Hülse 7 angelötet.

Der rückwärtige Bereich innerhalb des Sensorgehäuses 14 ist mit Vergußmasse 18 gefüllt, die einerseits den rückseitigen Bereich der Hülse 7 und andererseits die Anschlusslitze 17 nebst Kontaktbereich umgibt. Der Vorteil dieser Ausführungsform ist darin zu sehen, dass eine äußert kurze, kompakte Bauweise der Durchführung und somit des Sensors möglich ist. Gleichzeitig lässt sich die Spule 13 gegenüber Medien schützen, die auf Grund einer in der Praxis stets nachlassenden Abdichtung am Kabelmantel auf der Sensorrückseite in den Sensor eindringen könnten. Voranstehende Ausführungen machen deutlich, dass der Sensor im Lichte der voranstehenden Ausführungen sowohl messseitig als auch anschlussseitig hinreichend gut abgedichtet ist, nämlich unter Verwendung der erfindungsgemäßen Durchführung mit den dort vorgesehenen Abdicht- und Kontaktierungsmaßnahmen.

Hinsichtlich weiterer vorteilhafter Ausgestaltungen der erfindungsgemäßen Durchführung wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele der erfindungsgemäßen Durchführung lediglich zur Erörterung der beanspruchten Lehre dienen, diese jedoch nicht auf die Ausführungsbeispiele einschränken.

### Bezugszeichenliste

- 1: Durchführung
- 2: Bereich
- 3: Bereich
- 4: Wand
- 5: elektrischer Leiter
- 6: Durchgang
- 7: Hülse
- 8: Verglasung
- 9: Hart-/Weichlot
- 10: Kabelader
- 11: Anschlusskabel
- 12: Vergußmasse
- 13: Spule
- 14: Sensorgehäuse
- 15: Abdeckkappe
- 16: Spulendraht
- 17: Anschlusslitze
- 18: Vergußmasse

## Patentansprüche

1. Durchführung eines elektrischen Leiters (5) durch eine zwei Bereiche voneinander trennende Wand (4), wobei sich der Leiter (5) durch einen Durchgang (6) in der Wand (4), zu dieser beabstandet, erstreckt, wobei sich vorzugsweise in etwa koaxial durch den Durchgang (6) hindurch eine gegenüber dem Durchgang (6) elektrisch isolierte und hermetisch abgedichtete Hülse (7) erstreckt und wobei sich der elektrische Leiter (5) durch die Hülse (7) hindurch erstreckt,
**dadurch gekennzeichnet, dass** der elektrische Leiter (5) hermetisch abdichtend, vorzugsweise materialschlüssig, durch Weich- oder Hartlöten über die gesamte Länge der Hülse (7), mit der Hülse (7) verbunden ist.

2. Durchführung nach Anspruch 1, **dadurch gekennzeichnet, dass** die Abdichtung der Hülse gegenüber dem Durchgang ein Vergußmittel, beispielsweise ein Kunststoff, oder eine Verglasung ist.

3. Durchführung nach Anspruch 1 oder 2, **dadurch gekennzeichnet, dass** die Hülse aus Metall, vorzugsweise aus dem gleichen Material wie der elektrische Leiter, besteht.

4. Durchführung nach einem der Ansprüche 1 bis 3, **dadurch gekennzeichnet, dass** die Hülse aus einer Eisen-Nickel-Legierung hergestellt ist.

5. Durchführung nach einem der Ansprüche 1 bis 4, **dadurch gekennzeichnet, dass** die Abdichtung der Hülse gegenüber der Wand in etwa die gleiche thermische Ausdehnung wie die Hülse hat.

6. Durchführung nach einem der Ansprüche 1 bis 4, **dadurch gekennzeichnet, dass** die Abdichtung der Hülse gegenüber der Wand eine geringere thermische Ausdehnung als das Material der Wand hat.

7. Durchführung nach einem der Ansprüche 1 bis 6, **dadurch gekennzeichnet, dass** der elektrische Leiter als Litze, vorzugsweise als Kupferlitze, ausgeführt ist.

8. Durchführung nach einem der Ansprüche 1 bis 7, **dadurch gekennzeichnet, dass** die Wand Teil des Gehäuses eines Sensors, vorzugsweise eines induktiven Wegsensors ist und dass der elektrische Leiter vorzugsweise der Spulendraht des Sensors ist und zur elektrischen Kontaktierung zwischen Spule(n) und Anschlusskabel dient, wobei der Anschlußdraht an das anschlusseitige Ende der Hülse an diese und/oder an den elektrischen Leiter bzw. an den Spulendraht angelötet ist.

9. Durchführung nach einem der Ansprüche 1 bis 8, **dadurch gekennzeichnet, dass** im anschlussseitigen Bereich, vorzugsweise im Sensorgehäuse, eine Vergußmasse vorgesehen ist, die insbesondere das Sensorgehäuse zumindest teilweise ausfüllt, wobei die Vergußmasse beliebige Funktionselemente, insbesondere die Kontaktierung des elektrischen Leiters bzw. der Hülse und des Anschlusskabels umgibt und dabei weiterreichend abdichtet und stabilisiert.

## Claims

1. Bushing of an electrical conductor (5) through a wall (4) which separates two regions from each other, the conductor (5) extending through a passage (6) in the wall (4), with spacing therefrom, there extending in a preferably substantially coaxial manner through the passage (6) a sleeve (7) which is electrically insulated and hermetically sealed with respect to the passage (6) and the electrical conductor (5) extending through the sleeve (7),
**characterised in that** the electrical conductor (5) is connected to the sleeve (7) in a hermetically sealing manner, preferably in a materially integral manner, by means of soft or hard soldering over the entire length of the sleeve (7).

2. Bushing according to claim 1, **characterised in that** the sealing of the sleeve with respect to the passage is a casting means, for example, a plastics material, or a glazing member.

3. Bushing according to claim 1 or claim 2, **characterised in that** the sleeve comprises metal, preferably the same material as the electrical conductor.

4. Bushing according to any one of claims 1 to 3, **characterised in that** the sleeve is produced from an iron/nickel alloy.

5. Bushing according to any one of claims 1 to 4, **characterised in that** the sealing of the sleeve with respect to the wall has substantially the same thermal expansion as the sleeve.

6. Bushing according to any one of claims 1 to 4, **characterised in that** the sealing of the sleeve with respect to the wall has a smaller thermal expansion than the material of the wall.

7. Bushing according to any one of claims 1 to 6, **characterised in that** the electrical conductor is constructed as a strand, preferably as a copper strand.

8. Bushing according to any one of claims 1 to 7, **characterised in that** the wall is part of the housing of a sensor, preferably an inductive displacement sensor, and **in that** the electrical conductor is preferably the coil wire of the sensor and is used for electrical contacting between the coil(s) and connection cable, the connection wire being soldered to the sleeve at the connection-side end of the sleeve and/or being soldered to the electrical conductor or to the coil wire.

9. Bushing according to any one of claims 1 to 8, **characterised in that**, in the connection-side region, preferably in the sensor housing, there is provided a casting mass which in particular at least partially fills the sensor housing, the casting mass surrounding any functional elements, in particular the contacting of the electrical conductor or the sleeve and the connection cable and sealing and stabilising to a greater extent.

## Revendications

1. Guidage d'un conducteur électrique (5) à travers une paroi (4) séparant deux zones, le conducteur (5) s'étendant à travers un passage (6) dans la paroi (4), à une certaine distance de celui-ci, un manchon (7) isolé électriquement et hermétiquement étanche par rapport au passage (6) s'étendant de préférence de manière approximativement coaxiale à travers le passage (6) et le conducteur électrique (5) s'étendant à travers le manchon (7),
**caractérisé en ce que** le conducteur électrique (5) est relié au manchon (7) de manière hermétiquement étanche, de préférence avec liaison de matériau, par brasage doux ou dur sur toute la longueur du manchon (7).

2. Guidage selon la revendication 1, **caractérisé en ce que** l'étanchéification du manchon par rapport au passage est un produit d'étanchéité, de préférence une matière plastique ou un vitrage.

3. Guidage selon la revendication 1 ou 2, **caractérisé en ce que** le manchon est constitué de métal, de préférence du même matériau que le conducteur électrique.

4. Guidage selon l'une des revendications 1 à 3, **caractérisé en ce que** le manchon est constitué d'un alliage fer-nickel.

5. Guidage selon l'une des revendications 1 à 4, **caractérisé en ce que** l'étanchéification du manchon par rapport à la paroi présente approximativement la même dilatation thermique que le manchon.

6. Guidage selon l'une des revendications 1 à 4, **caractérisé en ce que** l'étanchéification du manchon par rapport à la paroi présente une dilatation thermique plus faible que le matériau de la paroi.

7. Guidage selon l'une des revendications 1 à 6, **caractérisé en ce que** le conducteur électrique est conçu comme un toron, de préférence comme un toron en cuivre.

8. Guidage selon l'une des revendications 1 à 7, **caractérisé en ce que** la paroi fait partie du boîtier d'un capteur, de préférence d'un capteur de déplacement inductif et **en ce que** le conducteur électrique est de préférence le fil de bobine du capteur et sert de contact électrique entre la ou les bobines et le câble de connexion, le fil de connexion étant brasé, au niveau de l'extrémité côté connexion du manchon, à celui-ci et/ou au conducteur électrique et au fil de bobine.

9. Guidage selon l'une des revendications 1 à 8, **caractérisé en ce que**, dans la zone côté connexion, de préférence dans le boîtier du capteur, se trouve une masse de scellement qui remplit plus particulièrement le boîtier du capteur au moins partiellement, la masse de scellement englobant des éléments fonctionnels quelconques, plus particulièrement le point de contact du conducteur électrique ou du manchon et du câble de connexion qui est ainsi étanchéifié et stabilisé.
